Europäisches Patentamt

European Patent Office

Office européen des brevets

(19)

(11) Veröffentlichungsnummer: **0 216 342 B1**

(12) **EUROPÄISCHE PATENTSCHRIFT**

(45) Veröffentlichungstag der Patentschrift: **31.07.91**

(51) Int. Cl.5: **B32B 27/32,** B32B 31/30, C23C 14/00

(21) Anmeldenummer: **86113015.1**

(22) Anmeldetag: **22.09.86**

(54) **Verfahren zum Herstellen einer Transfermetallisierungsfolie.**

(30) Priorität: **27.09.85 DE 3534398**

(43) Veröffentlichungstag der Anmeldung:
**01.04.87 Patentblatt 87/14**

(45) Bekanntmachung des Hinweises auf die
Patenterteilung:
**31.07.91 Patentblatt 91/31**

(84) Benannte Vertragsstaaten:
**BE DE FR GB IT NL**

(56) Entgegenhaltungen:
**EP-A- 0 021 672**
**DE-A- 2 235 673**
**DE-A- 3 203 806**
**DE-A- 3 434 298**

(73) Patentinhaber: **HOECHST AKTIENGESELL-
SCHAFT
Postfach 80 03 20
W-6230 Frankfurt am Main 80(DE)**

(72) Erfinder: **Paschke, Klaus, Dipl.-Ing.
Peterstrasse 9
W-6650 Homburg-Reiskirchen(DE)**
Erfinder: **Crass, Günther, Dipl.-Ing.
Bachstrasse 7
W-6204 Taunusstein 4(DE)**
Erfinder: **Dinter, Peter, Dipl.-Ing.
Am Wiesenberg 4
W-6227 Hallgarten(DE)**

## Beschreibung

Die Erfindung betrifft ein Verfahren zum Herstellen einer Transfermetallisierungsfolie, die auf einer Seite metallisiert wird, sowie eine Transfermetallisierungsfolie auf der Basis einer durch Koextrusion von Polypropylen hergestellten biaxial streckorientierten Mehrschichtfolie.

Für spezielle Verpackungszwecke besteht ein hoher Bedarf an Verbundmaterialien aus Papier und Metall, insbesondere Aluminiumfolie, der von Jahr zu Jahr höher steigt. Obgleich für derartige Verbundmaterialien schon extrem dünne Metallfolien eingesetzt werden und auch ausreichend sind, werden weitere Einsparungen des knappen und kostenintensiven Metalls durch den Einsatz metallisierter Papiere angestrebt. Die Metallisierung von Papier wird nach dem Stand der Technik nach zwei voneinander verschiedenen Verfahren durchgeführt. Nach dem ersten Verfahren wird Papier direkt im Hochvakuum mit Metall bedampft, nach dem zweiten Verfahren wird ein Fremdsubstrat mit einer Metallschicht bedampft, und diese wird dann auf das Papier übertragen. Das zweite Verfahren wird auch als Transfermetallisierung bezeichnet.

Für die direkte Bedampfung von Papier ist die Auswahl einer geeigneten Papierqualität ein entscheidender Faktor, ferner ist eine kostenaufwendige Vorbereitung des Papiers erforderlich. Diese Vorbereitung besteht entweder aus einer Versiegelung des Papiers mit einer Lackschicht oder aus einem Trocknungsschritt, bei dem der normale Wassergehalt des Papiers von 6 bis 7% auf ca. 3 % reduziert wird. Nach der Metallbedampfung muß das Papier dann wieder auf den normalen Wassergehalt gebracht werden. Diese Schritte sind kosten- und zeitaufwendig.

Bei der Transfermetallisierung wird eine Kunststoffolie, meist auf Basis von Polyolefin oder Polyester, im Hochvakuum bedampft. Die metallisierte Folie wird mit einem Haftkleber beschichtet und mit dem zu metallisierenden Papier, das in diesem Fall je nach Erfordernis der Endanwendung beliebig ausgewählt werden kann, zusammengebracht. Nach der Aushärtung des Haftklebers wird die Kunststoffolie von dem Verbund abgezogen, die Metallschicht verbleibt dabei auf dem Papier. Der Prozeß der Transfermetallisierung läßt sich nur dann wirtschaftlich durchführen, wenn die Kunststoffolie mehrfach zu verwenden ist. Herkömmliche Folien lassen sich normalerweise bis zu sechsmal wiederverwenden.

In der deutschen Patentanmeldung P 34 34 298.2 (Anmeldetag: 19.09.84; Offenlegungstag: 27.03.86) wird eine Folie aus thermoplastischem Polymeren beschrieben, die bei der Transfermetallisierung von der Folie auf Papier unter wirtschaftlichen Gesichtspunkten bis zu 20-mal wiederverwendbar ist. Jedoch tritt bei dem ersten Metallisierungsschritt schon ein gravierender, die Produktqualität erheblich störender und damit die Anwendbarkeit der Folie und des Verfahrens infrage stellender Nachteil auf. Es handelt sich hierbei um Blitzentladungen, die beispielsweise während des Aufdampfens der Metallschicht auf die Folie zu sogenannten "Lichtenbergschen Figuren" führen. Diese Figuren beeinträchtigen das einheitliche Erscheinungsbild der Metallschicht und führen nach dem Transfer der Metallschicht auf die Trägerschicht aus Papier oder auch aus Folienmaterial dazu, daß das Aussehen der Trägerschicht unansehnlich und somit für überwiegend dekorative Zwecke unbrauchbar wird.

Zur Überwindung dieses Problems sind verschiedene Anstrengungen, wie Metallisierung der zweiten Folienseite zwecks Ladungsableitung, intensive Entladung der Folie vor der Metallisierung mittels elektrischer Entladeeinrichtungen, antistatische Ausrüstung des Folienrohstoffes bzw. der Folienoberfläche, Flammbehandlung der nicht metallisierten Seite der Folie u.dgl. unternommen worden, die aber alle zusammen nicht den gewünschten Erfolg zeigten und zudem das Herstellungsverfahren für die Transfermetallisierungsfolie aufwendiger und damit in letzter Konsequenz teurer machen.

Aufgabe der vorliegenden Erfindung ist es, ein Verfahren anzugeben, das es ermöglicht, die elektrischen Entladungsphänomene während des einseitigen Aufdampfens einer Metallschicht auf eine Folie in einfacher Weise zu eliminieren.

Diese Aufgabe wird erfindungsgemäß dadurch gelöst, daß die Folienbahn einer Polypropylenfolie, vor dem ersten Aufbringen einer Metallschicht auf der einen Seite der Folienbahn, einer einseitigen elektrischen Coronaentladung auf der anderen, nicht zu metallisierenden Seite der Folienbahn ausgesetzt wird.

In Ausgestaltung des erfindungsgemäßen Verfahrens wird durch Evakuieren der Luft aus dem Inneren einer mit Öffnungen im Walzenmantel ausgestatteten hohlen Walzenelektrode, über die die Folienbahn geführt wird, ein von Lufteinschlüssen freier Kontakt zwischen der zu metallisierenden Seite der Folienbahn und dem Walzenmantel hergestellt und zugleich erfolgt die einseitige elektrische Coronaentladung zwischen einer Anzahl von Gegenelektroden und der von dem Walzenmantel abgewandten Seite der über die Walzenelektrode geführten Folienbahn.

Bei dem Verfahren genügt eine einmalige Anwendung einer elektrischen Coronaentladung beim Aufbringen einer Metallschicht, so daß vor dem zweiten und jedem weiteren Aufbringen einer Metallschicht auf der gleichen Seite der Polypropylenfolie ein Coronaentladungsschritt unterbleibt.

Als eine Folie, die vor dem ersten Metallisieren der einseitigen elektrischen Coronaentladung nach den voranstehend beschriebenen Verfahrensschritten ausgesetzt ist, wird beispielsweise eine Transfermetallisierungsfolie auf der Basis einer durch Koextrusion von Polypropylen hergestellten biaxial streckorientierten Mehrschichtfolie verwendet, bestehend aus einer Basisschicht aus Propylen-Homopolymeren und beidseitig darauf aufgebrachten Deckschichten, wobei die Basisschicht ein Additivdepot von migrierenden Monomeren in einer Menge von 0,01 bis 2,0 Gew.% enthält, bezogen auf das Gewicht des die Basisschicht bildenden Polymeren und die Deckschichten aus Polypropylen bestehen, das eine niedrigere Viskosität als das Polypropylen der Basisschicht aufweist.

Unter einem Additivdepot von migrierenden Monomeren ist ein additiver Zusatz zu der Basisschicht von solchen Verbindungen zu verstehen, die in der Lage sind, aufgrund von Diffusionskräften nach und nach aus der Basisschicht in die Deckschichten überzutreten und dort ihre Wirkungen zu entfalten. Die in der Basisschicht enthaltenen Additive sind dabei insbesondere eine Kombination von Stearinsäureamid und von einem Hydroxyethylalkylamin mit Alkylketten im Bereich von 14 bis 20 C-Atomen.

Die Deckschichten können bevorzugt zusätzlich noch die Gleitfähigkeit der Folie bzw. die Antiblockeigenschaften der Folie verbessernde inerte Zusatzmittel enthalten. Dies sind z.B. anorganische Zusatzstoffe wie Calciumcarbonat, Bariumsulfat, Siliziumdioxid, Aluminiumsilikat und ähnliche.

Weitere Einzelheiten einer derartigen Transfermetallisierungsfolie sind in der deutschen Patentanmeldung P 34 34 298.2 (Anmeldetag: 19.09.84; Offenlegungstag: 27.03.86) beschrieben.

Wesentlich ist beim Metallisieren der erfindungsgemäßen Folie, daß die elektrische Coronaentladung auf die Seite der Folienbahn aufgebracht wird, die nicht metallisiert wird. Die Metallisierung als solche erfolgt im allgemeinen durch Aufdampfen von Metall auf die Folie im Hochvakuum.

In jedem Fall muß bei dem Verfahren vermieden werden, daß die Coronaentladung auch die Seite der Folie erfaßt, die metallisiert wird, was nämlich zur Folge hätte, daß die aus der Coronaentladung resultierende gute Metallhaftung auf der Folienseite den späteren Transfervorgang der Metallschicht auf das zu veredelnde Papier - bzw. Foliensubstrat - verhindern könnte. In diesem Zusammenhang ist offensichtlich, daß die elektrische Coronaentladung nur dann eingesetzt werden kann, wenn sichergestellt ist, daß die mit der Coronaentladung verknüpfte, schädliche Begleiterscheinung des sogenannten Rückseiteneffekts ausgeschlossen wird. Der Fachmann versteht unter dem Rückseiteneffekt bei der elektrischen Coronavorbehandlung von Materialbahnen, insbesondere von Kunststoffolien, die ungewollte und unerwünschte Aussetzung der Folienbahnrückseite der Coronaentladung, wodurch ungünstige Haft- und Gleiteigenschaften der Folienbahn beim Auf- und Abwickeln bzw. Schichten sich bemerkbar machen. Die Ursache für den Rückseiteneffekt ist die unvollständige Auflage der Folienbahn auf der Walze, welche die eine Elektrode für die Coronaentladung bildet. Neben Oberflächendefekten des Walzenbelags wie beispielsweise Löcher, Poren, Druckstellen, Kratzer, führt vor allem Lufteinzug zwischen der Walzenoberfläche und der Folienbahn zum Rückseiteneffekt, da dann die Folienbahn nicht glatt auf der Walzenoberfläche aufliegt. Diese Erscheinung tritt insbesondere bei schnell laufenden, sehr breiten Anlagen zur Folienverarbeitung auf, bei denen die eingeschlossene Luft zwischen der Folienbahn und der Walzenoberfläche nicht mehr zu den Bahnrändern hin abströmen kann. Selbst ein nur partiell auftretender Rückseiteneffekt verursacht Schwierigkeiten bei der Übertragung der Metallschicht auf das Papier - bzw. Foliensubstrat - und beeinträchtigt die Wiederverwendbarkeit der Folie für weitere Metallisierungsschritte.

Da das Auftreten von Rückseiteneffekten ausschließlich eine Frage eines von Lufteinschlüssen freien Kontaktes zwischen der Folienbahn und der Walzenelektrode ist, muß für die Coronaentladung eine entsprechende Vorrichtung zur Oberflächenbehandlung von Folienbahnen mittels elektrischer Coronaentladung verwendet werden. Hierzu eignet sich im wesentlichen die in der deutschen Offenlegungsschrift DE-OS 32 03 806 beschriebene Vorrichtung, die aus einer Walzenelektrode, wenigstens einer dieser zugeordneten geerdeten Gegenelektrode sowie einem mit der Walzenelektrode über eine Zuleitung verbundenen Generator zur Erzeugung einer hochfrequenten Wechselspannung besteht. Die geerdeten Gegenelektroden können Spitzenelektroden in Form von Kämmen, Messern, Zähnen oder dünne Drähte sein. Die Walzenelektrode weist eine zentrale Hohlachse auf, die in ihrer Oberfläche Öffnungen besitzt und deren Innenhohlraum mit einer Vakuumpumpe zum Evakuieren der Luft verbunden ist. Ein äußeres und ein inneres Rohr der Walzenelektrode weisen gleichfalls eine Vielzahl von zwischen Einzelelektroden angeordneten Durchbohrungen auf, so daß eine Verbindung von der Oberfläche der Walzenelektrode zu dem Innenraum der Hohlachse der Walzenelektrode besteht. Bei einer derart ausgebildeten Vorrichtung wird der von der Folienbahn zwangsläufig eingezogene, störende Luftfilm durch Anlegen eines Vakuums an die Walzenelektrode entfernt und dadurch erreicht, daß die Folienbahn ohne Lufteinschlüsse satt auf der Oberfläche der Walzenelektrode aufliegt. Dadurch ist sichergestellt, daß die Folienbahn einer entsprechend intensiven Coronaentladung ausgesetzt werden kann, ohne daß die Gefahr besteht, daß die Coronaentladung auch auf die Rückseite, in diesem Fall auf die an die Walzenoberfläche angesaugte Seite der Folienbahn, übergreifen kann.

Durch das Verfahren, die Transfermetallisierungsfolie vor ihrer ersten Metallisierung einer elektrischen Coronaentladung auszusetzen, wird das Phänomen der bei der Metallisierung auftretenden Blitzentladungen auf einfache und wirkungsvolle Weise beseitigt, so daß die Folie für ihren vorgesehenen Einsatz, nämlich der Mehrfach-Wiederverwendbarkeit als Träger für zu übertragende Metallschichten, zur Verfügung steht.

## Patentansprüche

1. Verfahren zum Herstellen einer Transfermetallisierungsfolie, die auf einer Seite metallisiert wird, dadurch gekennzeichnet, daß die Folienbahn einer Polypropylenfolie, vor dem ersten Aufbringen einer Metallschicht auf der einen Seite der Folienbahn, einer einseitigen elektrischen Coronaentladung auf der anderen, nicht zu metallisierenden Seite der Folienbahn ausgesetzt wird.

2. Verfahren nach Anspruch 1, dadurch gekennzeichnet, daß durch Evakuieren der Luft aus dem Inneren einer mit Offnungen im Walzenmantel ausgestatteten hohlen Walzenelektrode, über die die Folienbahn geführt wird, ein von Lufteinschlüssen freier Kontakt zwischen der zu metallisierenden Seite der Folienbahn und dem Walzenmantel hergestellt wird und zugleich die einseitige elektrische Coronaentladung zwischen einer Anzahl von Gegenelektroden und der von dem Walzenmantel abgewandten Seite der über die Walzenelektrode geführten Folienbahn erfolgt.

3. Verfahren nach den Ansprüchen 1 und 2, dadurch gekennzeichnet, daß vor dem zweiten und jedem weiteren Aufbringen einer Metallschicht auf der gleichen Seite der Polypropylenfolie ein Coronaentladungsschritt unterbleibt.

4. Transfermetallisierungsfolie auf der Basis einer durch Koextrusion von Polypropylen hergestellten biaxial streckorientierten Mehrschichtfolie, bestehend aus einer Basisschicht aus Propylen-Homopolymeren und beidseitig darauf aufgebrachten Deckschichten, wobei die Basisschicht ein Additivdepot von migrierenden Monomeren in einer Menge von 0,01 bis 2,0 Gew.% enthält, bezogen auf das Gewicht des die Basisschicht bildenden Polymeren und die Deckschichten aus Polypropylen bestehen, das eine niedrigere Viskosität als das Polypropylen der Basisschicht aufweist, dadurch gekennzeichnet, daß die Folie vor dem ersten Metallisieren der einseitigen elektrischen Coronaentladung nach den Verfahrensschritten gemäß der Ansprüche 1 und 2 ausgesetzt ist.

## Claims

1. Process for preparing a transfer metallization film which is metallized on one side, wherein the film web of a polypropylene film, before the first application of a metal layer onto one side of the film web, is subjected to a one-sided electric corona discharge on the other side of the film web, i.e. on the side which is not to be metallized.

2. The process as claimed in claim 1, wherein the air is evacuated from the interior of a hollow drum electrode which is equipped with openings in the drum shell and over which the film web is guided, to establish contact which is free from air inclusions between the film web side to be metallized and the drum shell, and at the same time the onesided electric corona discharge takes place between a number of counterelectrodes and that side of the film web guided over the drum electrode which faces away from the drum shell.

3. The process as claimed in claims 1 and 2, wherein a corona discharge step is dispensed with before the second and any further application of a metal layer to the same side of the polypropylene film.

4. Transfer metallization film based on a biaxially stretch-oriented multilayer film prepared by coextruding polypropylene and comprising a base layer of propylene homopolymer and, applied thereto on both sides, top layers, the base layer containing an additive depot of migrating monomers in an amount of 0.01 to 2.0% by weight, based on the weight of the polymer forming the base layer, and the top layers comprising polypropylene which has a lower viscosity than the polypropylene of the base layer, wherein the film is exposed before the first metallization to the one-sided electric corona discharge of the process steps claimed in claims 1 and 2.

## Revendications

1. Procédé pour la production d'une feuille de métallisation par transfert, qui est métallisée sur un côté, caractérisé en ce que la bande continue d'une feuille de polypropylène, avant la première application d'une couche de métal sur un côté de la bande continue de feuille, est exposée d'un côté à une décharge électrique en couronne, sur l'autre côté de la bande continue de feuille non destinée à être métallisée.

2. Procédé selon la revendication 1, caractérisé en ce qu'un contact exempt d'inclusions d'air est établi entre le côté à métalliser de la bande continue de feuille et le bandage du cylindre, par évacuation de l'air hors de la partie interne d'une électrode en forme de cylindre creux, munie d'orifices dans le bandage du cylindre, sur laquelle est amenée la bande continue de feuille, et en même temps s'effectue la décharge électrique en couronne d'un côté entre un certain nombre de contre-électrodes et le côté, opposé au bandage du cylindre, de la bande continue de feuille amenée sur l'électrode en forme de cylindre.

3. Procédé selon les revendications 1 et 2, caractérisé en ce qu'une étape de décharge en couronne n'a pas lieu avant la seconde et toute application ultérieure d'une couche de métal sur le même côté de la feuille de polypropylène.

4. Feuille de métallisation par transfert à base d'une feuille multicouche produite par co-extrusion de polypropylène et orientée biaxialement par étirage, constituée d'une couche de base en homopolymère de propylène et de couches de recouvrement appliquées des deux côtés sur celleci, la couche de base contenant d e s additifs constitués de monomères migrants, en une quantité de 0,01 à 2,0 % en poids, par rapport au poids du polymère constituant la couche de base, et les couches de recouvrement étant constituées de polypropylène présentant une viscosité inférieure à celle du polypropylène de la couche de base, caractérisée en ce que la feuille est exposée, avant la première métallisation, à la décharge électrique en couronne d'un côté, selon les étapes de procédé conformes aux revendications 1 et 2.